# EUROPÄISCHE PATENTSCHRIFT

(11) **EP 0 361 143 B1**
(45) Veröffentlichungstag und Bekanntmachung des Hinweises auf die Patenterteilung: **30.08.1995**
(21) Anmeldenummer: 89116380.0
(22) Anmeldetag: 05.09.1989
(51) Int. Cl.: G06F 12/06, G11C 7/00

(54) **Schaltungsanordnung zur Durchführen eines On-Chip-Zeitverschachtelns des Zugriffs auf dynamische RAM-Bausteine**
Circuitry for the on-chip interleaved access to dynamic RAM modules
Circuit sur microplaquette permettant l'accès entrelacé à des modules de mémoire dynamiques à accès aléatoire

(30) Priorität: 29.09.1988 DE 3833095
(43) Veröffentlichungstag der Anmeldung: 04.04.1990
(73) Patentinhaber: SIEMENS AKTIENGESELLSCHAFT, 80333 München (DE)
(72) Erfinder: Legutko, Christoph, Dipl.-Ing., D-8000 München 70 (DE); Niedermeier, Thomas, Dipl.-Ing., D-8000 München 19 (DE); Rauh, Doris, Dipl.-Math., D-8000 München 83 (DE); Schäfer, Eberhard, Dipl.-Ing., D-8025 Unterhaching (DE); Thurner, Erwin, Dipl.-Ing., D-8000 München 70 (DE)

(56) Entgegenhaltungen:
- DE-A- 3 727 688
- IBM TECHNICAL DISCLOSURE BULLETIN, Band 25, Nr. 6, November 1982, Seiten 3042- 3044, New York, US; J.C. LEININGER: "Microprocessor interleave instruction"
- ELECTRONIC ENGINEERING, Band 58, Nr. 710, Februar 1986, Seiten 87-92, London, GB; P. BAGNALL et al.: "A hierarchical RAM with multi-level access path - part 2"

## Beschreibung

Die vorliegende Erfindung betrifft eine Speicheranordnung mit einem dynamischen Speicher (DRAMs), einem Adreßbus und einem Datenbus.

Bisher wird ein Zeitverschachteln (Interleaving) auf Baustein-Ebene angewandt. Die derzeitige DRAM-Architektur läßt zeitverschachtelte oder verschränkte Zugriffe nur dann zu, wenn ungleiche Bausteine angesprochen werden. Dabei steuert eine zusätzlich erforderliche externe Logik die Bausteinzugriffe und erkennt Konfliktfälle. Diese bekannte Technik ist aufwendig und hat u. a. den Nachteil eines höheren Platzbedarfs. Siehe z.B. IBM Technical Disclosure Bulletin, Bd. 25,Nr. 6, Nov. 1982, Seiten 3042 bis 3044, New York, US; J.C. LEININGER : "Microprocessor interleave instruction".

Aus DE-A 3 727 688 ist weiterhin bekannt, daß ein Speicher mit zwei Speicherblöcken auf einem Substrat integrierbar ist. Diese beiden Speicherblöcke können zeitverschachtelt angesteuert werden und können zeitverschachtelt Daten am Ausgang abgeben.

Der Erfindung liegt die Aufgabe zugrunde, eine Speicheranordnung gemäß DE-A-3 727 688 weiter zu verbessern.

Zur Lösung der Aufgabe wird eine Speicheranordnung gemäß den Merkmalen des Patentanspruchs 1 vorgeschlagen.

Im folgenden wird die Erfindung anhand mehrerer Figuren im einzelnen beschrieben.
- Fig. 1: zeigt ein Blockschaltbild der erfindungsgemäßen Schaltungsanordnung.
- Fig. 2: zeigt eine diagrammartige Darstellung des zeitlichen Ablaufs von Vorgängen auf dem Adreßbus und dem Datenbus der Schaltungsanordnung bei konfliktfreiem Zugriff auf die dynamischen RAM-Bausteine.

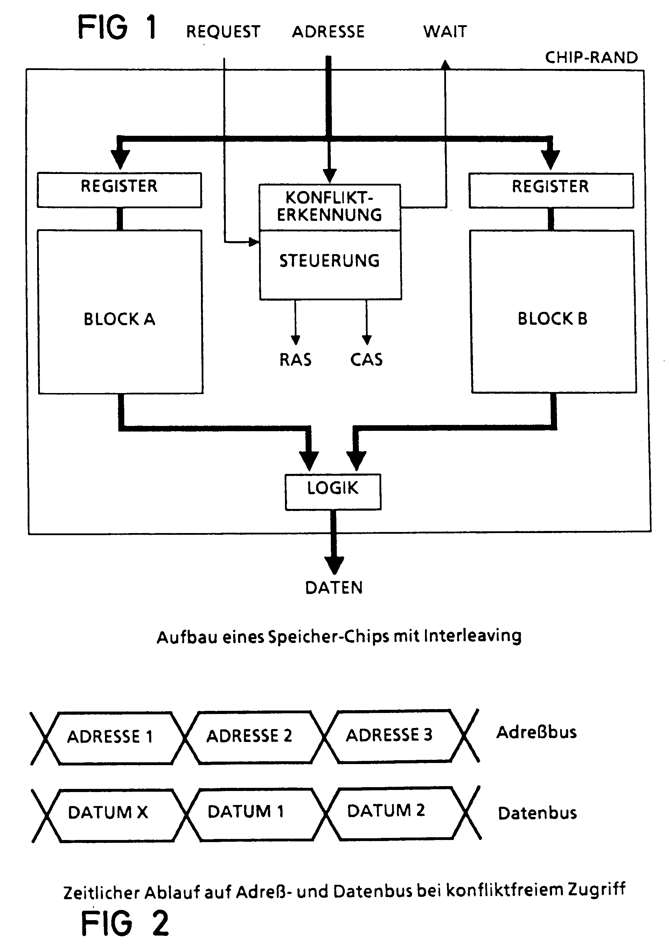

Wie Fig. 1 zeigt, ist das Speicherfeld eines Chips in 2ⁿ Blöcke A, B (n>0) mit vorgeschalteten Registern unterteilt. Ein gemeinsamer On-Chip-Adreßbus versorgt jeden dieser Blöcke A, B. Die Blockadressen werden über diesen Bus im Zeitmultiplex übertragen. Der maximale Verschränkungsgrad ist vom Verhältnis der Gesamtzyklusdauer zur Dauer einer Adreßübertragung begrenzt. Eine erhöhte Blockanzahl verringert die Wahrscheinlichkeit eines Konflikts. Die einzelnen Blöcke A, B werden über die n niederwertigsten Bits der Adreßcodes ausgewählt. Eine das zeitliche Verschränken von Adressierung und Datenausgabe bewirkende Logik legt die ausgelesenen Daten auf den gemeinsamen, nach außen geführten Datenbus. Liegt ein Adreßstrom mit nichtsequentiellen Adressen vor, können Konflikte auftreten, wenn auf Blöcke zugegriffen wird, die noch belegt sind. Konflikte haben verzögerte Zugriffe zur Folge. Eine On-Chip-Logik Konflikterkennung erkennt diese Konflikte und teilt sie über Signale (WAIT) der "Außenwelt" mit. Ebenso wird die sog. RAS- und CAS-Zeitsteuerung von einer geeigneten internen Logik (Steuerung) durchgeführt.

Fig. 2 zeigt die zeitliche Zuordnung der Vorgänge auf dem Adreßbus und dem Datenbus.

Die erfindungsgemäße Schaltungsanordnung bewirkt eine Verkürzung der mittleren Zugriffszeit dynamischer RAM-Bausteine (DRAMs) bei schnell aufeinanderfolgenden Speicheranforderungen durch eine sog. Interleaving-Technik.

## Patentansprüche

1. Speicheranordnung mit einem dynamischen Speicher (D-RAM), einem Adreßbus und einem Datenbus,
- bei der der Speicher in 2ⁿ Blöcke (A,B) unterteilt ist, wobei n>0 ist,
- bei der jedem Block (A,B) jeweils ein Register vorgeschaltet ist,
- bei der die Register eingangsseitig mit dem Adreßbus verbunden sind,
- bei der die Blöcke mit dem Datenbus über eine gemeinsame Datenausgabelogik verbunden sind, die eine zeitliche Verschränkung der Datenausgabe aus den Blöcken zu den an die Blöcke angelegten Adressen bewirkt, sodaß schon während der Datenausgabe aus einem Block bereits die nächste Adresse über den Adreßbus den Blöcken zuführbar ist,
- bei der eine Konflikterkennungslogik mit dem Adreßbus verbunden ist, die bei einem Zugriffskonflikt, der bei einem weiteren Zugriff auf einen Block, der gerade Daten ausgibt, auftritt, ein Konfliktsignal (wait) abgibt,
- bei der eine CAS(Column Adress Signal)/RAS(Row Adress Signal) Steuerlogik vorgesehen ist, die Zeitsteuersignale für die Speicherblöcke erzeugt,
- und bei der die Speicheranordnung auf einem Chip angeordnet ist.

## Claims

1. Memory arrangement having a dynamic memory (D-RAM), an address bus and a data bus,
- in which the memory is subdivided into 2ⁿ blocks (A, B), n being greater than 0,
- in which each block (A, B) is respectively preceded by a register,
- in which the registers are connected on the input side to the address bus,
- in which the blocks are connected to the data bus via a common data output logic, which effects an interleaving of the data output from the blocks to the addresses applied to the blocks, so that even during the data output from one block the next address can already be fed via the address bus to the blocks,
- in which there is connected to the address bus a conflict detection logic which, in the event of a conflict of access which occurs when there is a further access to a block which is in the process of outputting data, emits a conflict signal (wait),
- in which there is provided a CAS (Column Address Signal)/RAS (Row Address Signal) control logic, which generates the timing signals for the memory blocks,
- and in which the memory arrangement is arranged on a chip.

## Revendications

1. Dispositif de mémorisation comportant une mémoire dynamique (D-RAM), un bus d'adresse et un bus de données,
- dans lequel la mémoire est subdivisée en 2ⁿ blocs (A,B), n>0,
- dans lequel un registre est branché en amont de chaque bloc (A,B),
- dans lequel les registres sont reliés du côté entrée au bus d'adresse,
- dans lequel les blocs sont reliés au bus de données par l'intermédiaire d'un circuit logique commune de fourniture de données, qui provoque un entrelacement temporel de la fourniture des données provenant des blocs aux adresses appliquées aux blocs, de sorte que l'adresse suivante puisse être envoyée par l'intermédiaire du bus d'adresse aux blocs déjà pendant la fourniture des données à partir d'un bloc,
- dans lequel une unité logique de reconnaissance de conflit, qui, en cas de conflit d'accès apparaissant lors d'un autre accès à un bloc fournissant justement des données, fournit un signal (wait) de conflit, est reliée au bus d'adresse,
- dans lequel une unité logique de commande CAS (Column Adress Signal)/RAS (Row Adress Signal), qui produit des signaux de commande temporelle pour les blocs de mémoire, est prévue,
- et dans lequel le dispositif de mémorisation est disposé sur une puce.
